(19) Europäisches Patentamt
European Patent Office
Office européen des brevets

(11) Publication number: **0 162 698**
**B1**

(12) # EUROPEAN PATENT SPECIFICATION

(45) Date of publication of patent specification: 25.04.90

(51) Int. Cl.$^5$: **H 01 B 1/22, C 08 K 3/08**

(21) Application number: 85303563.2

(22) Date of filing: 21.05.85

(54) **Solderable conductive compositions, methods for their preparation, and substrates coated with them.**

(30) Priority: 21.05.84 US 612184

(43) Date of publication of application:
27.11.85 Bulletin 85/48

(45) Publication of the grant of the patent:
25.04.90 Bulletin 90/17

(84) Designated Contracting States:
AT BE CH DE FR GB IT LI LU NL SE

(56) References cited:
EP-A-0 144 741
US-A-4 353 816

(73) Proprietor: ELECTRO MATERIALS CORP. OF AMERICA
605 Center Avenue
Mamaroneck New York 10543 (US)

(72) Inventor: St. John, Frank
1 Webster Place
Patterson New York 12563 (US)
Inventor: Martin, Frank Wayne
P.O. Box 243
Baldwin Place New York 10505 (US)

(74) Representative: Angell, David Whilton
ROHM AND HAAS (UK) LTD. European
Operations Patent Department Lennig House
2 Mason's Avenue
Croydon CR9 3NB (GB)

EP 0 162 698 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention is concerned with those conductive compositions that are generally referred to in the art as polymer thick films and their production. Conductive compositions of the invention may demonstrate improved solderability.

The prior art discloses electrically conductive resinous compositions containing metal powders or flakes or combinations thereof, with various resins, for example, epoxy resins, phenolic resins and polyester resins.

U.S. Patent 3,412,043 discloses an electrically conductive resinous composition consisting essentially of silver flake, resinous binder, and finely divided inert filler. This patent is based upon the discovery that conductive cements and coatings, which have excellent electrical and physical properties, can be prepared by incorporating therein a substantial amount of inert filler.

U.S. Patent 3,030,237 discloses an improved coating composition essentially comprised of an organic resin carrier and a suitable metallic pigment. The coating and the electrical equipment to which it is applied have improved adhesion and electrical operating characteristics in comparison with conventional conducting coating materials. In connection with printed circuit boards, conventional wire leads may be silver-soldered to the cured coating using a common silver-soldering technique.

U.S. Patent 2,280,135 discloses a conductive coating composition comprising metal of the group consisting of nickel, tin, bismuth, cadmium, chromium and silver, in the form of finely divided flakes, dispersed in a liquid medium comprising a film-forming organic substance and a volatile solvent therefor. These coatings are opaque and are of low light reflectivity on glass and the like.

U.S. Patent 4,353,816 discloses a power conductive coating consisting of a mixture in a liquid condition of 70—85 wt. % of copper powder, 15—30 wt. % of at least one of phenol resin, epoxy resin, polyester resin and xylene resin, and 0.2—5 wt. % of at least one annex agent selected from the group of anthracene, anthracene carbonylic acid, anthranylic acid and anthrazine.

The prior art compositions are deficient in that they are not readily solderable, i.e. directly solderable using ordinary techniques.

It has been a long sought goal to provide electrically conductive resinous compositions which are readily solderable and which would utilize available materials to achieve the desired purpose at economic cost.

In order for a polymer matrix to be highly electrically conductive it must contain metal. However, a polymer matrix containing non-precious metal is not ordinarily readily solderable. Those materials that claim solderability can only do so under closely controlled processing conditions; the temperature and time must be too closely controlled to be useful in a typical manufacturing environment. The use of precious metals such as gold and silver is an alternative; however, it can be well appreciated that because of the high cost of these materials this method is expensive. Present day polymer conductors typically do contain silver or gold but they are also not directly solderable using ordinary techniques.

Preferred embodiments of the present invention may enable the provision of compositions which, while they may contain non-precious metals, are, nevertheless solderable, even directly solderable using ordinary techniques.

According to one aspect of the present invention there is provided a solderable conductive composition which comprises, dispersed in organic polymeric matrix, metal and/or alloy thereof, said organic polymeric matrix comprising one or more thermoset resin selected from epoxy resins and phenolic resins, and said metal and/or alloy being coated with saturated monocarboxylic acid comprising one or more acids of the formula:

O
||
R—C—OH

wherein R is a hydrocarbon group of the general formula $C_nH_{2n+1}$ wherein n is an integer from 10 to 18.

Another aspect of the present invention comprises a process for preparing the conductive compositions of the invention, the process comprising coating metal and/or alloy thereof with one or more saturated monocarboxylic acid, and subsequently dispersing the coated metal and/or alloy thereof in organic polymeric matrix, and wherein the saturated monocarboxylic acid comprises one or more acids of the formula:

O
||
R—C—OH

wherein R is a hydrocarbon group of the general formula $C_nH_{2n+1}$ wherin n is an integer from 10 to 18, and the organic polymeric matrix comprises one or more thermoset resin selected from epoxy resins and phenolic resins. In one application of this embodiment the organic polymeric matrix can be dissolved in a solvent and metal and/or alloy thereof coated with saturated monocarboxylic acid(s) can then be dispersed in the resultant solution. The mixture formed thereby may be applied to a substrate and subsequently cured. Examples of solvent that may be used to dissolve the organic polymeric matrix are esters such as butyl carbitol acetate. The mixture which is applied to the substrate may, for example, be cured by heating at temperatures from 125°C to 200°C for 30 seconds to two hours.

The metal and/or alloy thereof may be coated with one or more saturated monocarboxylic acid by dissolving the saturated monocarboxylic acid(s) in solvent, adding the metal and/or alloy thereof to the resultant solution and evaporating the solvent, for example, to leave a dry powder or

flake which is coated with saturated monocarboxylic acid(s).

The metal and/or alloy thereof used in the present invention may be any metal and/or alloy, for example, transition or non-transition metal. However, tranition metals are preferred. More preferably the metal and/or alloy thereof comprises nickel. Hereinafter the term "metal" will be used to include metals and/or alloys thereof.

The metal may, for example, be present in the conductive composition in an amount of from 50% to 85% by weight, and the ratio of metal to organic polymeric matrix may, for example, be from 50:50 to 85:15, by weight.

Generally, the size, shape and form of the metal employed in the present invention is not limited. However, when the composition is to be applied to a substrate by a silk screening procedure, the upper limit of the particle size of the metal is 125 micrometres, with 1—10 micrometres being the preferred range for the particle size.

Preferably the metal is in the form of powder, flake or sponge as those terms are known and understood by those skilled in the art to which this invention pertains.

In the present invention the metal is coated with one or more saturated monocarboxylic acid, e.g. fatty acid. Both commercial grade acids and also synthetic grade acids may, for example, be used. Unsaturated carboxylic acids are not effective.

Saturated monocarboxylic acids that may, for example, be employed include decanoic, undecanoic, n-tridecanoic, tetradecanoic, n-pentadecanoic, hexadecanoic, n-heptadecanoic, octadecanoic, nonadecanoic and dodecanoic acids. Preferably octadecanoic acid is used. Most preferably, n-heptadecanoic acid is used.

The organic polymeric matrix used in the invention comprises thermoset resin selected from epoxy resins and phenolic resins, these thermoset resins being capable of maintaining their integrity (that is, they substantially hold together and do not disintegrate) in the solder bath under processing conditions.

The composition of the present invention may conveniently have a ratio of metal to organic polymeric matrix of from 5:3 to 20:1, by weight. Preferably the ratio of metal to organic polymeric matrix is about 10:1, by weight. Additionally, the composition may conveniently have a ratio of carboxylic acid to metal of from 1:1000 to 1:30, by weight. The preferred ratio of saturated monocarboxylic acid to metal is about 1:100, by weight.

A composition according to the present invention can be applied to a substrate by any suitable means, for example, by silk screening, dipping, brushing or spraying. The composition is usually applied at a thickness of from 15 to 50 micrometres.

The article produced by applying the composition of the invention to a substrate may, for example, be a laminate, preferably a laminate comprising a printed circuit board having a composition according to the present invention applied thereto. It is preferable to use the silk screening procedure when the composition is to be applied to printed circuit boards and, in this connection, it should be remembered, as discussed above, that the upper limit of the particle size of the metal used in such procedure is 125 micrometres, with the preferred range being 1—10 micrometres. The composition of the invention is capable of being applied to and performing satisfactorily on a wide range of substrates.

The process of coating metal, preferably in the form of powder or flake, with saturated monocarboxylic acid(s) is carried out in a step which is separate from the dispersal of the coated metal and/or alloy thereof in the organic polymeric matrix. In this process the percent addition of saturated monocarboxylic acid(s) to metal is conveniently in the range of 0.1 to 3%, preferably 1% by weight.

In the coating of metal with saturated monocarboxylic acid(s), in accordance with the present invention, the saturated monocarboxylic acid(s) must be soluble in the solvent. Suitable solvents include esters, preferably butyl carbitol acetate, and alcohols, preferably isopropyl alcohol. Water is unsuitable as a solvent.

In one convenient process for the coating of metal with saturated monocarboxylic acid(s), the saturated monocarboxylic acid(s) is/are added to the solvent and a sufficient time is then allowed for the carboxylic acid(s) to dissolve in the solvent. The metal is then added to the resultant solution by any suitable means and again a sufficient time is then allowed for the metal to become coated with the saturated monocarboxylic acid(s).

After the coating of the metal with the saturated monocarboxylic acid(s) has occurred, the solvent is then allowed to evaporate at room temperature. Heat may be applied but care needs to be taken to avoid fire or explosion. After evaporation of the solvent, metal coated with saturated monocarboxylic acid(s) remains. The metal in this state is visually virtually indistinguishable from when it is in its uncoated state.

Solderability of a metallic surface refers to the ability of the metallic surface to be wetted with solder. The more easily the metallic surface is wetted with solder, the more readily solderable the surface is said to be. The present invention is applicable to the provision of conductive compositions for use in any method of soldering.

The present invention will now be further illustrated by way of the following Examples which are for illustrative purposes only and are not to be construed as imposing any limitation on the scope of the invention.

The resin employed in the examples of the present invention was made by mixing an o-creosol novolac resin (hydroxyl type) with an epoxy creosol novolac resin. The o-creosol novolac resin (hydroxyl type) is a multifunctional epoxy resin supplied by Ciba Geigy (HT/9490). The epoxy creosol novolac resin is a polyepoxide resin made by reacting orthocreosol novolac with

epichlorohydrin. The polyepoxide resin so produced contains no more than two epoxy groups per molecule. This resin is also supplied by Ciba Geigy (ECN 1273).

Examples

Example I

Process for coating metal

One tenth of a gram of octadecanoic acid was dissolved in five grams of isopropyl alcohol. To this was added ten grams of finely divided nickel flake. The alcohol was then allowed to evaporate, at room temperature, from the resulting mixture. The metallic flake was now substantially coated with the saturated monocarboxylic acid.

Example II

Preparation of polymer thick film containing coated metal

An epoxy resin mixture was made up by mixing 20% of o-creosol novolac resin (hydroxy type), 40% epoxy creosol novolac resin and 40% butyl carbitol acetate with the resultant mixture placed on a shaker and shaken until the solids were dissolved in the solvent.

Three grams of coated nickel flake (coated as in Example I) was dispersed into one gram of the epoxy. Several passes of this paste through a 3 roll mill yielded a smooth creamy ink.

This ink was then screen printed onto glass epoxy type substrates to form test patterns. These printed parts were placed in a box oven at 165°C for 30 minutes to cure the films. After removal from the oven and cooling, the printed parts were fluxed with a rosin type flux (Kester 1544) and dipped into molten solder.

The result was a substantially smooth shiny coverage of solder on the printed pattern.

Example III

Preparation of polymer thick film without coated metal

The procedure of Example II was followed exactly except that the metal was not coated with saturated monocarboxylic acid. The film was substantially non-solderable; almost none of the film accepted solder.

## Claims

1. A solderable conductive composition which comprises, dispersed in organic polymeric matrix, metal and/or alloy thereof, said organic polymeric matrix comprising one or more thermoset resin selected from epoxy resins and phenolic resins, and said metal and/or alloy being coated with saturated monocarboxylic acid comprising one or more acids of the formula:

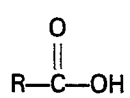

wherein R is a hydrocarbon group of the general formula $C_nH_{2n+1}$ wherein n is an integer from 10 to 18.

2. A composition as claimed in claim 1 wherein the metal comprises nickel.

3. A composition as claimed in claim 1 or claim 2 wherein the saturated monocarboxylic acid comprises one or more of n-heptadecanoic acid, hexadecanoic acid, octadecanoic acid, tetradecanoic acid, n-pentadecanoic acid, decanoic acid, undecanoic acid, nonadecanoic acid, dodecanoic acid and n-tridecanoic acid.

4. A compsition as claimed in any of claims 1 to 3 wherein the metal and/or alloy is in the form of powder, flake and/or sponge.

5. A composition as claimed in any of claims 1 to 4 wherein the ratio of metal and/or alloy thereof to organic polymeric matrix is from 5:3 to 20:1, by weight.

6. A composition as claimed in any of claims 1 to 4 wherein the ratio of metal and/or alloy thereof to organic polymeric matrix is from 50:50 to 85:15, by weight.

7. A composition as claimed in any of claims 1 to 6 wherein the ratio of saturated monocarboxylic acid to metal and/or alloy thereof is from 1:1000 to 1:30, by weight.

8. A composition as claimed in any of claims 1 to 7 wherein the metal and/or alloy thereof is present in an amount of from 50% to 85%, by weight.

9. A composition as claimed in any of claims 1 to 8 wherein the saturated monocarboxylic acid is present in an amount of from 0.1 to 3%, by weight.

10. A process for preparing a conductive composition as claimed in any of claims 1 to 9 comprising coating metal and/or alloy thereof with saturated monocarboxylic acid and subsequently dispersing the coated metal and/or alloy thereof in organic polymeric matrix, and wherein the saturated monocarboxylic acid comprises one or more acids of the formula:

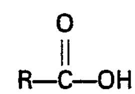

wherein R is a hydrocarbon group of the general formula $C_nH_{2n+1}$ wherein n is an integer from 10 to 18, and the organic polymeric matrix comprises one or more thermoset resin selected from epoxy resins and phenolic resins.

11. A process as claimed in claim 10 wherein the saturated monocarboxylic acid is dissolved in solvent, the metal and/or alloy thereof is added to the resultant solution and the solvent is evaporated or allowed to evaporate.

12. A process of treating a substrate comprising (i) dissolving organic polymeric matrix in solvent, the organic polymeric matrix comprising one or more thermoset resin selected from epoxy resins and phenolic resins; (ii) dispersing metal and/or alloy thereof coated with saturated monocarboxylic acid therein to form a mixture,

the saturated monocarboxylic acid comprising one or more acids of the formula:

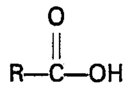

wherein R is a hydrocarbon group of the general formula $C_nH_{2n+1}$ wherein n is an integer from 10 to 18; (iii) applying said mixture to a substrate; and (iv) then curing the mixture.

13. A process as claimed in claim 12 wherein the mixture is cured at a temperature of from 125°C to 200°C for 30 seconds to two hours.

14. A process as claimed in claim 12 or claim 13 wherein the metal and/or alloy thereof comprises nickel.

15. A process as claimed in any of claims 12 to 14 wherein the organic polymeric matrix is an epoxy resin, and/or the solvent is butyl carbitol acetate, and/or the metal comprises nickel.

16. A process as claimed in any of claims 12 to 15 wherein the saturated monocarboxylic acid(s) comprise(s) octadecanoic and/or n-heptadecanoic acid.

17. A substrate comprising a film of a conductive composition as claimed in any of claims 1 to 9 or obtained in accordance with claim 11 or claim 12.

18. A substrate as claimed in claim 17 wherein the film is a dried and cured film.

19. A substrate as claimed in claim 17 or claim 18 which is a printed circuit board.

**Patentansprüche**

1. Lötbare leitende Masse aus einem Metall und/oder einer Legierung davon, verteilt in einer organischen polymeren Matrix, wobei die organische polymere Matrix eines oder mehrere hitzegehärtete Harze aufweist, ausgewählt aus Epoxiharzen und Phenolharzen, und das Metall und/oder die Legierung mit einer gesättigten Monocarbonsäure aus einer oder mehreren Säuren der Formel

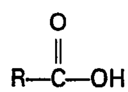

überzogen ist, wobei R eine Kohlenwasserstoffgruppe der allgemeinen Formel $C_nH_{2n+1}$ ist, wobei n eine ganze Zahl von 10 bis 18 ist.

2. Masse nach Anspruch 1, wobei das Metall aus Nickel besteht.

3. Masse nach Anspruch 1 oder 2, wobei die gesättigte Monocarbonsäure aus einer oder mehreren der Verbindungen n-Heptadecansäure, Hexadecansäure, Octadecansäure, Tetradecansäure, n-Pentadecansäure, Decansäure, Undecansäure, Nonadecansäure, Dodecansäure und n-Tridecansäure besteht.

4. Masse nach einem der Ansprüche 1 bis 3, wobei das Metall und/oder die Legierung in Form eines Pulvers, von Flocken und/oder eines Schwamms vorliegt.

5. Masse nach einem der Ansprüche 1 bis 4, wobei das Verhältnis von Metall und/oder Legierung davon zu der organischen polymeren Matrix 5:3 bis 20:1, bezogen auf das Gewicht, beträgt.

6. Masse nach einem der Ansprüche 1 bis 4, wobei das Verhältnis von Metall und/oder Legierung davon zu der organischen polymeren Matrix 50:50 bis 85:15, bezogen auf das Gewicht, beträgt.

7. Masse nach einem der Ansprüche 1 bis 6, wobei das Verhältnis der gesättigten Monocarbonsäure zu dem Metall und/oder der Legierung davon 1:1000 bis 1:30, bezogen auf das Gewicht, beträgt.

8. Masse nach einem der Ansprüche 1 bis 7, wobei das Metall und/oder die Legierung davon in einer Menge von 50 bis 85 Gew.-% vorliegen.

9. Masse nach einem der Ansprüche 1 bis 8, wobei die gesättigte Monocarbonsäure in einer Menge von 0,1 bis 3 Gew.-% vorliegt.

10. Verfahren zur Herstellung einer leitenden Masse gemäß einem der Ansprüche 1 bis 9 durch Beschichten von Metall und/oder einer Legierung davon mit einer gesättigten Monocarbonsäure und anschließendes Verteilen des beschichteten Metalls und/oder der Legierung davon in einer organischen polymeren Matrix, wobei die gesättigte Monocarbonsäure aus einer oder mehreren Säuren der Formel

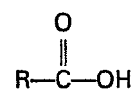

besteht, worin R eine Kohlenwasserstoffgruppe der allgemeinen Formel $C_nH_{2n+1}$ ist, wobei n eine ganze Zahl von 10 bis 18 ist, und die organische polymere Matrix eines oder mehrere hitzegehärtete Harze aufweist, ausgewählt aus Epoxiharzen und Phenolharzen.

11. Verfahren nach Anspruch 10, wobei die gesättigte Monocarbonsäure in dem Lösungsmittel aufgelöst ist, das Metall und/oder die Legierung davon der erhaltenen Lösung zugesetzt wird und das Lösungsmittel verdampft oder verdampfengelassen wird.

12. Verfahren zur Behandlung eines Substrats durch (i) Auflösen einer organischen polymeren Matrix in einem Lösungsmittel, wobei die organische polymere Matrix eines oder mehrere hitzegehärtete Harze aufweist, ausgewählt aus Epoxiharzen und Phenolharzen, (ii) Verteilen eines Metalls und/oder einer Legierung davon, beschichtet mit einer gesättigten Monocarbonsäure, darin unter Bildung einer Mischung, wobei die gesättigte Monocarbonsäure aus einer oder mehreren Säuren der Formel

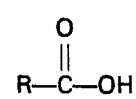

besteht, worin R eine Kohlenwasserstoffgruppe der allgemeinen Formel $C_nH_{2n+1}$ ist, wobei n eine ganze Zahl von 10 bis 18 ist, (iii) Auftragen dieser Mischung auf eine Substrat und (iv) anschließendes Härten der Mischung.

13. Verfahren nach Anspruch 12, wobei die Mischung bei einer Temperatur von 125 bis 200°C während 30 Sekunden bis 2 Stunden gehärtet wird.

14. Verfahren nach Anspruch 12 oder 13, wobei das Metall und/oder die Legierung davon Nickel aufweist.

15. Verfahren nach einem der Ansprüche 12 bis 14, wobei die organische polymere Matrix ein Epoxiharz ist und/oder das Lösungsmittel Butylcarbitolacetat ist und/oder das Metall aus Nickel besteht.

16. Verfahren nach einem der Ansprüche 12 bis 15, wobei die gesättigte Monocarbonsäure(n) aus Octadecansäure und/oder Heptadecansäure besteht (bestehen).

17. Substrat aus einem Film aus einer leitenden Masse gemäß einem der Ansprüche 1 bis 9 oder erhalten gemäß Anspruch 11 oder Anspruch 12.

18. Substrat nach Anspruch 17, wobei der Film ein getrockneter und gehärteter Film ist.

19. Substrat nach Anspruch 17 oder 18, welches eine gedruckte Schaltung ist.

**Revendications**

1. Une composition conductrice soudable qui comprend, en dispersion dans une matrice polymère organique, un métal et/ou un alliage de celui-ci, ladite matrice polymère organique comprenant une ou plusieurs résines thermodurcies choisies parmi les résines époxydes et les résines phénoliques, ledit métal et/ou ledit alliage étant revêtus d'un acide monocarboxylique saturé comprenant un ou plusieurs acides de formule:

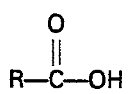

dans laquelle R est un groupe hydrocarboné de formule générale $C_nH_{2n+1}$, dans laquelle n est un entier de 10 à 18.

2. Une composition selon la revendication 1, dans laquelle le métal comprend du nickel.

3. Une composition selon la revendication 1 ou la revendication 2, dans laquelle l'acide monocarboxylique saturé comprend un ou plusieurs de l'acide n-heptadécanoïque, l'acide hexadécanoïque, l'acide octadécanoïque, l'acide tétradécanoïque, l'acide n-pentadécanoïque, l'acide décanoïque, l'acide undécanoïque, l'acide nonadécanoïque, l'acide dodécanoïque, et l'acide n-tridécanoïque.

4. Une composition selon l'une quelconque des revendications 1 à 3, dans laquelle le métal et/ou son alliage sont sous forme d'une poudre, de paillettes et/ou d'éponge.

5. Une composition selon l'une quelconque des revendications 1 à 4, dans laquelle le rapport du métal et/ou de son alliage à la matrice polymère organique est de 5/3 à 20/1 en poids.

6. Une composition selon l'une quelconque des revendications 1 à 4, dans laquelle le rapport du métal et/ou de son alliage à la matrice polymère organique est de 50/50 à 85/15 en poids.

7. Une composition selon l'une quelconque des revendications 1 à 6, dans laquelle le rapport de l'acide monocarboxylique saturé au métal et/ou son alliage est de 1/1 000 à 1/30 en poids.

8. Une composition selon l'une quelconque des revendications 1 à 7, dans laquelle le métal et/ou son alliage sont présents en une quantité de 50% à 85% en poids.

9. Une composition selon l'une quelconque des revendications 1 à 8, dans laquelle l'acide monocarboxylique saturé est présent en une quantité de 0,1 à 3% en poids.

10. Un procédé pour préparer une composition conductrice selon l'une quelconque des revendications 1 à 9 comprenant le revêtement d'un métal et/ou d'un de ses alliages avec un acide monocarboxylique saturé, puis la dispersion du métal et/ou de son alliage revêtus dans une matrice polymère organique, et dans lequel l'acide monocarboxylique saturé comprend un ou plusieurs acides de formule:

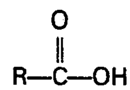

dans laquelle R est un groupe hydrocarboné de formule générale $C_nH_{2n+1}$, dans laquelle n est un entier de 10 à 18, et la matrice polymère organique comprend une ou plusieurs résines thermodurcies choisies parmi les résines époxydes et les résines phénoliques.

11. Un procédé selon la revendication 10, dans lequel on dissout l'acide monocarboxylique saturé dans un solvant, on ajoute le métal et/ou son alliage à la solution obtenue et on évapore le solvant ou on le laisse s'évaporer.

12. Un procédé de traitement d'un substrat comprenant (i) la dissolution d'une matrice polymère organique dans un solvant, la matrice polymère organique comprenant une ou plusieurs résines thermodurcies choisies parmi les résines époxydes et les résines phénoliques; (ii) la dispersion dans la solution d'un métal et/ou d'un alliage de celui-ci revêtus d'un acide monocarboxylique saturé pour former un mélange, l'acide monocarboxylique saturé comprenant un ou plusieurs acides de formule:

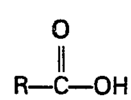

dans laquelle R est un groupe hydrocarboné de formule générale $C_nH_{2n+1}$, dans laquelle n est un entier de 10 à 18; (iii) l'application dudit mélange à un substrat; puis (iv) le durcissement du mélange.

13. Un procédé selon la revendication 12, dans lequel le mélange est durci à une température de 125°C à 200°C pendant 30 secondes à deux heures.

14. Un procédé selon la revendication 12 ou la revendication 13, dans lequel le métal et/ou son alliage comprennent du nickel.

15. Un procédé selon l'une quelconque des revendications 12 à 14, dans lequel la matrice polymère organique est une résine époxyde et/ou le solvant est l'acétate de butylcarbitol et/ou le métal comprend du nickel.

16. Un procédé selon l'une quelconque des revendications 12 à 15, dans lequel le ou les acides monocarboxyliques saturés comprennent l'acide octadécanoïque et/ou l'acide n-heptadécanoïque.

17. Un substrat comprenant une pellicule d'une composition conductrice selon l'une quelconque des revendications 1 à 9 ou obtenue selon la revendication 11 ou la revendication 12.

18. Un substrat selon la revendication 17, dans lequel la pellicule est une pellicule séchée et durcie.

19. Un substrat selon la revendication 17 ou la revendication 18, qui est une plaque à circuit imprimé.